# FASCICULE DE BREVET EUROPEEN

(11) **EP 2 897 234 B1**
(45) Date de publication et mention de la délivrance du brevet: **17.02.2016**
(21) Numéro de dépôt: 14198337.9
(22) Date de dépôt: 16.12.2014
(51) Int. Cl.: H01R 13/6587, H01R 13/6594, H05K 1/11, H01R 24/64, H01R 13/6463, H01R 4/24, H05K 1/02, H01R 24/28, H01R 31/06

(54) **Prise RJ45 mâle pour cordon de raccordement électrique RJ45**
RJ45-Stecker für elektrisches RJ45-Verbindungskabel
Male RJ45 plug for RJ45 electrical connection cord

(30) Priorité: 17.01.2014 FR 1450403
(43) Date de publication de la demande: 22.07.2015
(73) Titulaire: Legrand France, 87000 Limoges (FR); Legrand SNC, 87000 Limoges (FR)
(72) Inventeur: Guitard, Julien, 38160 Saint Antoine L'Abbaye (FR); Grigis, Vincent, 38470 Notre Dame De l'Osier (FR)
(74) Mandataire: Santarelli

(56) Documents cités:
- US-A1- 2009 142 968
- US-A1- 2011 201 234
- US-B2- 8 298 922

## Description

### DOMAINE DE L'INVENTION

L'invention concerne le domaine de la connectique et plus précisément les prises RJ45 mâles pour cordons de raccordement RJ45 configurés pour interconnecter des équipements électroniques et/ou informatiques.

### ARRIERE PLAN TECHNOLOGIQUE

On connaît du brevet américain US 8,298,922 une telle prise RJ45 mâle pour cordon de raccordement RJ45, pourvue d'un circuit imprimé présentant deux faces opposées et des pistes de cheminement électrique sur chacune de ces faces, un système de séparation configuré pour séparer des paires de fils conducteurs que comporte le cordon de raccordement RJ45, et une coque externe métallique enveloppant partiellement le circuit imprimé.

Le système de séparation des paires de fils conducteurs comporte deux sous-ensembles similaires réalisés en matière non conductrice et montés de part et d'autre sur les faces du circuit imprimé.

La prise RJ45 comporte quatre dispositifs de contact auto-dénudant montés en saillie sur chacune des faces du circuit imprimé, ainsi qu'une paroi de blindage montée également en saillie sur chacune des faces du circuit imprimé.

Chaque sous-ensemble de séparation comporte un corps dans lequel sont ménagées quatre cavités d'insertion configurées pour recevoir deux paires de fils conducteurs, quatre rainures configurées pour recevoir chacune une extrémité d'un dispositif de contact auto-dénudant respectif, ainsi qu'une fente d'insertion configurée pour accueillir une paroi de blindage respective.

### OBJET DE L'INVENTION

L'invention vise à fournir une prise RJ45 mâle d'un genre similaire, qui soit particulièrement simple, commode et économique tant à la fabrication qu'à l'utilisation.

L'invention a ainsi pour objet, sous un premier aspect, une prise RJ45 mâle pour cordon de raccordement électrique RJ45 pourvu d'un câble ayant quatre paires de fils conducteurs configurées pour être connectées électriquement à ladite prise mâle, laquelle comporte un circuit imprimé présentant une première face et une deuxième face opposée à ladite première face, ainsi qu'une pluralité de pistes de cheminement électrique auxquelles lesdites paires de fils conducteurs sont configurées pour être connectées électriquement, un système d'épanouissement monté sur ledit circuit imprimé et configuré pour séparer, isoler électriquement et blinder électriquement lesdites paires de fils conducteurs les unes des autres ; ladite prise mâle étant caractérisée en ce que :
- ledit circuit imprimé comporte au moins une plaque de masse prise en sandwich entre ses première et deuxième faces et une fente centrale traversante s'étendant longitudinalement dans ledit circuit imprimé et débouchant sur un côté dudit circuit imprimé, ladite fente centrale traversante étant configurée pour traverser à la fois lesdites première et deuxième faces et ladite au moins une plaque de masse électrique ;
- ledit système d'épanouissement comporte un corps séparateur et un corps d'extension en saillie dudit corps séparateur, ledit corps d'extension étant pourvu d'un évidement configuré pour recevoir ledit circuit imprimé et d'une paroi centrale de blindage électrique et/ou magnétique divisant ledit évidement en deux parties et étant configurée pour s'insérer au moins en majeure partie dans ladite fente centrale traversante dudit circuit imprimé ;
et ladite paroi centrale de blindage électrique et/ou magnétique et ladite au moins une plaque de masse dudit circuit imprimé sont configurées pour être interconnectées électriquement et ainsi former une barrière de blindage électrique et/ou magnétique entre chaque paire de fils conducteurs.

La barrière de blindage électrique et/ou magnétique qui est créée entre chaque emplacement pour les paires de fils conducteurs, fils qui sont eux-mêmes configurés pour être connectés électriquement à cette prise mâle, permet avantageusement de fournir à la prise mâle selon l'invention des performances particulièrement élevées en matière de diaphonie.

En effet, le niveau de diaphonie généré entre les paires de fils conducteurs dans la prise RJ45 mâle selon l'invention est ici rendu négligeable, ou presque, grâce au cloisonnement à la fois des paires de fils qui sont juxtaposées dans le système d'épanouissement, par l'intermédiaire de la paroi centrale de blindage électrique et/ou magnétique qui est insérée dans la fente du circuit imprimé, et des paires de fils qui sont superposées dans le système d'épanouissement, par l'intermédiaire de ladite au moins une plaque de masse du circuit imprimé qui est insérée dans l'évidement du corps d'extension du système d'épanouissement.

Selon des caractéristiques préférées, simples, commodes et économiques, la prise mâle comporte en outre une enveloppe métallique configurée pour envelopper au moins partiellement ledit circuit imprimé, et ladite paroi centrale de blindage électrique et/ou magnétique, ladite au moins une plaque de masse et ladite enveloppe métallique sont configurées pour être interconnectées électriquement et ainsi former sensiblement une cage individuelle de blindage électrique et/ou magnétique autour de chaque paire de fils conducteurs.

Cela permet de créer une barrière de blindage électrique et/ou magnétique encore plus performante et ainsi rendre encore plus négligeable le niveau de diaphonie généré entre les paires de fils conducteurs dans la prise RJ45 mâle selon l'invention.

Selon des caractéristiques préférées, simples, commodes et économiques de la prise RJ45 mâle selon l'invention :
- ladite paroi centrale de blindage électrique et/ou magnétique est pourvue d'une extrémité supérieure et d'une extrémité inférieure opposée à ladite extrémité supérieure, et d'au moins une protubérance ménagée en saillie d'au moins une dite extrémité supérieur et/ou inférieure et configurée pour être au moins partiellement reçue dans au moins une cavité ménagée dans ladite enveloppe métallique ;
- ladite prise mâle comporte en outre des plaquettes de contact configurées pour être fixées sur ledit circuit imprimé et un corps de contact configuré pour être monté sur lesdites plaquettes de contact, et ladite enveloppe métallique est pourvue d'une portion en renfoncement et/ou d'une portion en élévation contre laquelle est positionné ledit corps de contact ;

- ladite prise mâle comporte en outre une pièce d'encliquetage configurée pour immobiliser ladite prise mâle dans une prise femelle dans laquelle ladite prise mâle est configurée pour être montée, et ladite enveloppe métallique est pourvue d'une portion en renfoncement et/ou d'une portion en élévation contre laquelle est positionnée ladite pièce d'encliquetage ;
- ladite enveloppe métallique est formée en deux parties, respectivement un corps de prise configuré pour recevoir ledit circuit imprimé et ledit système d'épanouissement, ainsi qu'un capot de prise configuré pour être monté sur ledit corps de prise et pour recouvrir ledit circuit imprimé et ledit système d'épanouissement ;
- ledit circuit imprimé est pourvu d'au moins une encoche ménagée sur au moins un côté dudit circuit imprimé et ladite enveloppe métallique est pourvue d'au moins un plot de contact configuré pour coopérer avec ladite au moins une encoche de sorte à établir une liaison électrique entre ladite au moins une plaque de masse et ladite enveloppe métallique ;
- ledit système d'épanouissement comporte en outre des systèmes de contact auto-dénudant configurés pour établir une connexion électrique entre lesdites paires de fils conducteurs et lesdites pistes de cheminement électrique dudit circuit imprimé, chaque système de contact auto-dénudant étant pourvu de deux organes de contact auto-dénudant et d'un corps moulé configuré pour recevoir au moins partiellement et isoler électriquement l'un de l'autre lesdits organes de contact auto-dénudant, ledit corps d'extension dudit système d'épanouissement comporte deux pièces de positionnement montées sur ladite paroi centrale de part et d'autre dudit évidement, et chaque corps moulé est fixé à la fois sur une dite pièce de positionnement respective et sur ledit corps séparateur ;
- au moins une dite pièce de positionnement présente une face externe sur laquelle est ménagée au moins une surface d'appui et ladite enveloppe métallique est pourvue d'au moins un organe de contact et de positionnement configuré pour venir en appui sur ladite au moins une surface d'appui ; et/ou au moins une dite pièce de positionnement présente des bossages latéraux et ladite enveloppe métallique présente au moins une face interne pourvue de rainures qui sont configurées pour coopérer avec lesdits bossages latéraux, de sorte à établir une liaison électrique entre l'épanouisseur et l'enveloppe métallique ;
- chaque corps moulé est pourvu d'une face de fond tournée vers ledit évidement, de trois murets longitudinaux situés à distance les uns des autres et s'étendant à l'opposé de ladite face de fond, de deux espaces d'insertion ménagés chacun entre deux murets successifs et s'étendant chacun transversalement dans ledit corps moulé jusqu'à déboucher dans ladite face de fond, et chaque organe de contact auto-dénudant est introduit dans un dit espace insertion respectif et saille de part et d'autre de cet espace ;
- chaque corps moulé est pourvu d'une face de fond et d'au moins une nervure ménagée sur ladite face de fond et saillant dans ledit évidement ménagé dans ledit corps d'extension, ladite au moins une nervure étant configurée pour guider ledit circuit imprimé dans ledit évidement ;
- ledit corps séparateur est pourvu de premières pattes d'accroche s'étendant vers une dite pièce de positionnement respective, laquelle est pourvue d'au moins une deuxième patte d'accroche s'étendant en regard d'une dite première patte d'accroche respective, et chaque corps moulé est pourvu de deux extrémités en forme de pince montées respectivement sur une dite première patte d'accroche et sur une dite deuxième patte d'accroche en regard de cette dernière ;
- ledit corps séparateur comporte une base métallique en forme de croix ayant une paroi centrale et deux parois latérales disposées de part et d'autre de la paroi centrale, ladite paroi centrale ayant une extrémité supérieure et une extrémité inférieure opposée à ladite extrémité supérieure, et au moins une protubérance ménagée en saillie d'au moins une dite extrémité supérieure et/ou inférieure et configurée pour être au moins partiellement reçue dans au moins une cavité ménagée dans ladite enveloppe métallique ; et/ou
- ledit corps séparateur comporte une base métallique en forme de croix ayant une paroi centrale et deux parois latérales disposées de part et d'autre de la paroi centrale et présentant chacune une portion pourvue de bossages latéraux et ladite enveloppe métallique présente au moins une face interne pourvue de rainures qui sont configurées pour coopérer avec lesdits bossages latéraux, de sorte à établir une liaison électrique entre l'épanouisseur et l'enveloppe métallique.

L'invention a aussi pour objet, sous un second aspect, un cordon de raccordement RJ45 configuré pour interconnecter des équipements électroniques et/ou informatiques, comportant un câble électrique ayant une première extrémité et une deuxième extrémité opposée à la première extrémité, une gaine isolante et quatre paires de fils conducteurs enveloppées dans ladite gaine ; et au moins une prise RJ45 mâle telle que décrite ci-dessus, montée sur au moins une dite première extrémité et/ou deuxième extrémité dudit câble.

Le cordon de raccordement selon l'invention est ainsi particulièrement simple, commode et économique tant à la fabrication qu'à l'utilisation.

### BREVE DESCRIPTION DES DESSINS

On va maintenant poursuivre l'exposé de l'invention par la description d'un exemple de réalisation, donné ci-après à titre illustratif et non limitatif, en référence aux dessins annexés sur lesquels :
- la figure 1 représente schématiquement, en perspective, un cordon de raccordement RJ45 conforme à l'invention, pourvu d'un câble et de deux prises mâles fixées à deux extrémités opposées du câble ;
- la figure 2 représente schématiquement, en perspective éclatée, une première prise mâle à une première extrémité du câble du cordon illustré sur la figure 1 ;
- les figures 3 et 4 représentent schématiquement les deux faces d'un circuit imprimé que comporte chacune des prises mâles du cordon ;
- la figure 5 est une vue en coupe du circuit imprimé prise selon l'axe V-V sur la figure 3 ;
- les figures 6 et 7 représentent, schématiquement en perspective, un épanouisseur de la première prise mâle illustrée sur la figure 2, pris selon différents angles de vue ;
- les figures 8 et 9 représentent, schématiquement en perspective, respectivement un corps de prise et un capot de prise, formant une enveloppe métallique que comporte la première prise mâle illustrée sur la figure 2 ;
- les figures 10 à 13 représentent, schématiquement en perspective, différentes étapes d'assemblage de la première prise mâle illustrée sur la figure 2 ; et
- la figure 14 est une vue en coupe prise selon l'axe XIV-XIV sur la figure 13.

### DESCRIPTION DETAILLEE D'UN EXEMPLE DE REALISATION

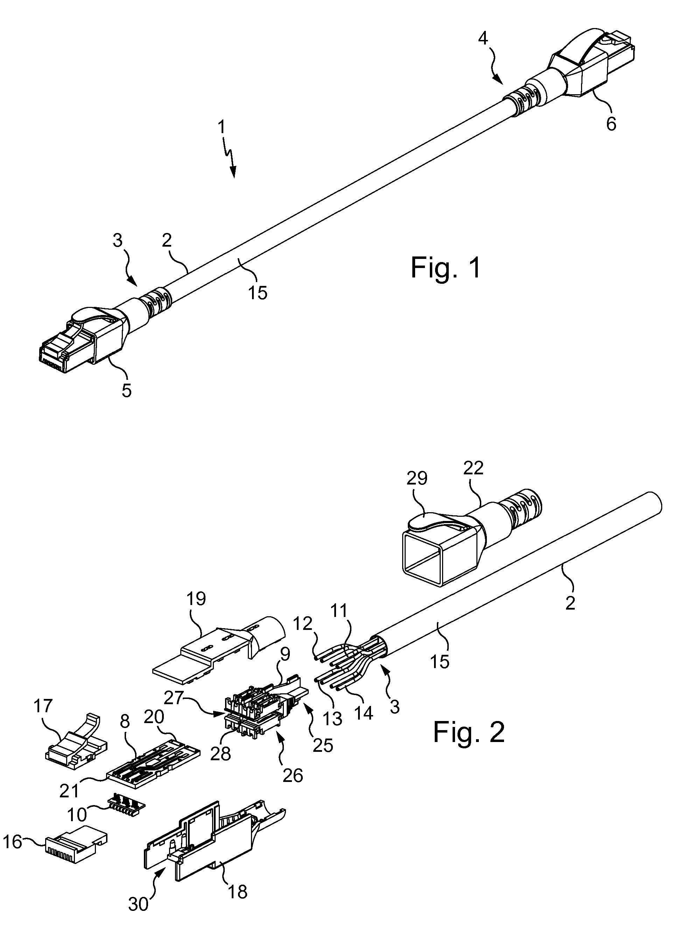

La figure 1 illustre un cordon de raccordement RJ45 (« Registered Jack » en terminologie anglo-saxonne), référencé 1, configuré pour interconnecter des équipements électroniques et/ou informatiques.

Ce cordon 1 comporte un câble électrique 2 ayant une première extrémité 3 et une deuxième extrémité 4 opposée à la première extrémité 3.

Ce cordon 1 comporte en outre une première prise mâle 5 montée sur la première extrémité 3 du câble 2 et une deuxième prise mâle 6 montée sur la deuxième extrémité 4 du câble 2.

Les prises mâles 5 et 6 sont ici formées par des fiches mâles et sont configurées pour être introduites dans des prises femelles respectives (non illustrées), formées par des socles femelles.

Le câble 2 comporte une gaine isolante 15 et quatre paires de fils conducteurs torsadés 11 à 14 enveloppées dans la gaine 15, respectivement une première paire de fils 11, une deuxième paire de fils 12, une troisième paire de fils 13 et une quatrième paire de fils 14 (figure 2).

Dans l'exemple illustré et décrit, la première paire de fils 11 correspond à la paire bleue de fils conducteurs de la norme de câblage de télécommunication ANSI/TIA/EIA 568-B, la deuxième paire de fils 12 correspond à la paire orange de fils conducteurs de cette norme, la troisième paire de fils 13 correspond à la paire verte de fils conducteurs de cette norme et la quatrième paire de fils 14 correspond à la paire marron de fils conducteurs de cette norme.

Le câble 2 présente ici un blindage électrique et/ou magnétique, formé par exemple par un ou plusieurs treillis métalliques (non représentés) entourant au moins partiellement les paires de fils conducteurs 11 à 14.

Ce blindage électrique et/ou magnétique s'étend par exemple le long du câble 2 entre les première et deuxième prises mâles 5 et 6 ou est au moins situé au niveau des première et deuxième extrémités 3 et 4 du câble 2.

Les première et deuxième prises mâles 5 et 6 comportent les mêmes éléments agencés d'une manière similaire entre eux et sur les extrémités respectives 3 et 4 du câble 2. Seule la première prise mâle 5 montée sur la première extrémité 3 du câble 2, illustrées sur la figure 2, est ici décrite de façon globale.

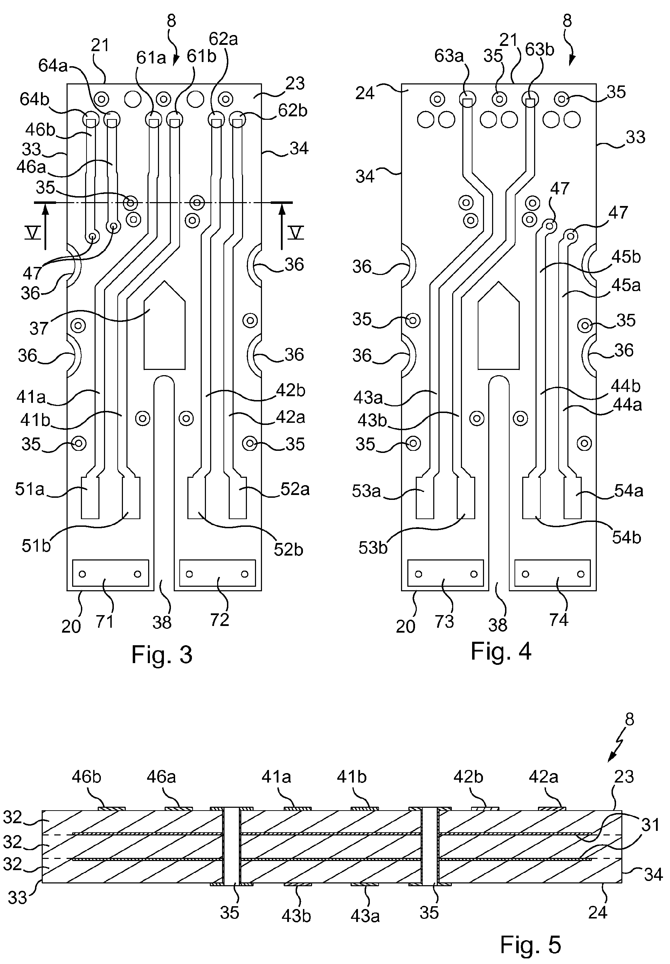

La première prise mâle 5 comporte un circuit imprimé 8 pourvu d'une première face 23 et d'une deuxième face 24 opposée à la première face 23 (figures 3 et 4), et d'une pluralité de pistes de cheminement électrique 41 à 44 ménagées sur ces première et deuxième faces 23 et 24.

La première prise mâle 5 comporte un système d'épanouissement 9, ci-après appelé épanouisseur, configuré pour être monté d'un premier côté 20 du circuit imprimé 8, de part et d'autre de ses première et deuxième faces 23 et 24, pour connecter électriquement les paires de fils 11 à 14 aux pistes 41 à 44 du circuit imprimé 8.

L'épanouisseur 9 présente ici un corps séparateur 25 et un corps d'extension 26 en saillie du corps séparateur 25. Le corps d'extension 26 présente un évidement de réception 27 du circuit imprimé 8 et est pourvu d'une paroi centrale 28 de blindage électrique et/ou magnétique divisant cet évidement 27 en deux parties.

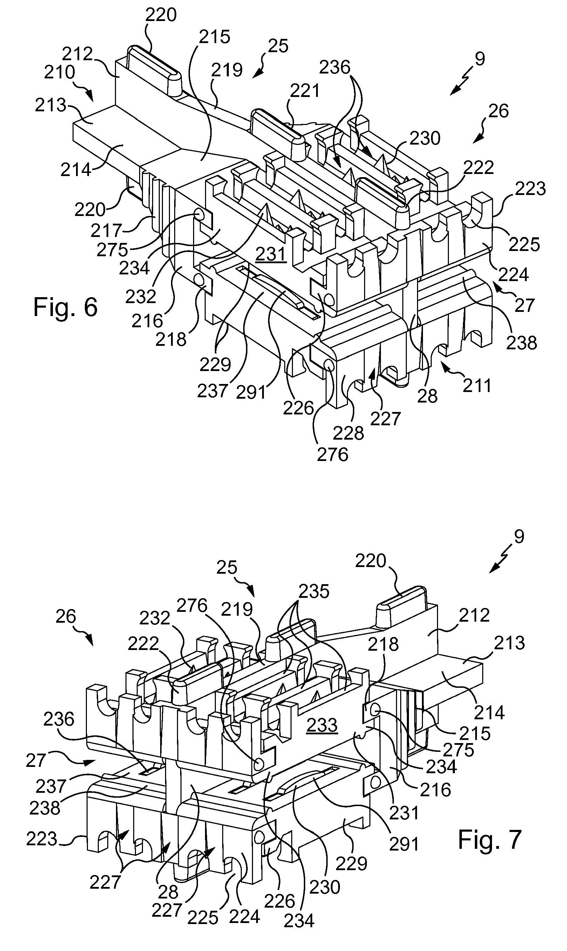

Le corps séparateur 25 est ici configuré pour séparer et diriger les paires de fils conducteurs 11 à 14 les unes des autres tandis que le corps d'extension 26 est ici configuré pour établir les connexions électriques entre ces fils conducteurs 11 à 14 et les pistes 41 à 44 du circuit imprimé 8. Le corps d'extension 26 présente ici des systèmes de contact auto-dénudant 229 (figures 6 et 7) pour établir ces connexions électriques.

La première prise mâle 5 comporte des plaquettes de contact 10 configurées pour être montées d'un second côté 21 du circuit imprimé 8, opposé à son premier côté 20, pour connecter électriquement les pistes 41 à 44 du circuit imprimé 8 à des organes de contact d'une prise femelle correspondante (non illustrés).

Les plaquettes de contact 10 sont ici configurées pour être montées sur l'une ou l'autre des première et deuxième faces 23 et 24 du circuit imprimé 8 (voir ci-après plus en détail).

La première prise mâle 5 comporte en outre un corps de contact 16 configuré pour être monté sur les plaquettes de contact 10 et être au moins partiellement introduit dans la prise femelle.

La première prise mâle 5 comporte une pièce d'encliquetage 17 configurée pour être montée du second côté 21 du circuit imprimé 8, à l'opposé du corps de contact 16, et être au moins partiellement introduite et verrouillée par encliquetage dans la prise femelle de sorte à immobiliser la première prise mâle 5 dans cette dernière.

Le corps de contact 16 est ainsi monté sur la même face du circuit imprimé 8 que les plaquettes de contact 10, tandis que la pièce d'encliquetage 17 est ici montée sur l'autre face du circuit imprimé 8.

La première prise mâle 5 comporte en outre une enveloppe ici métallique et formée d'un corps de prise 18 et d'un capot de prise 19 configurés pour être assemblées l'un avec l'autre et ainsi envelopper, au moins en majeure partie, le circuit imprimé 8, l'épanouisseur 9 et les plaquettes de contact 10.

Comme on le verra ci-après plus en détails, la première prise mâle 5 est configurée de sorte que le corps de prise 18, le capot de prise 19, le circuit imprimé 8 et l'épanouisseur 10 sont connectés électriquement ensemble.

Le corps de prise 18 forme ici une demi-coquille inférieure définissant un espace interne 30 configuré pour recevoir le circuit imprimé 8 et présentant une paroi de fond (non représentée) configurée pour être en regard de la face du circuit imprimé 8 sur laquelle sont montées les plaquettes de contacts 10.

Le capot de prise 19 forme ici une demi-coquille supérieure configurée pour être montée notamment sur le circuit imprimé 8 et sur l'épanouisseur 9 et présente une paroi supérieure (non représentée) configurée pour être en regard de la face du circuit imprimé 8 qui est opposée à celle sur laquelle sont montées les plaquettes de contacts 10.

La première prise mâle 5 comporte en outre un manchon 22 ici sensiblement tubulaire, réalisé en matière plastique, et configuré pour recouvrir l'extrémité 3 du câble 2 ainsi que partiellement le corps de prise 18 et le capot de prise 19.

Ce manchon 22 comporte une languette déformable 29 configurée pour venir en appui sur l'extrémité d'une patte déformable de la pièce d'encliquetage 17, pour déverrouiller la première prise mâle 5 de la prise femelle.

On va maintenant décrire plus en détail le circuit imprimé 8 en référence aux figures 3 à 5.

Le circuit imprimé 8 est ici formé d'une structure multicouches, dont trois couches dites de substrat 32 et quatre couches dites de cuivre 31 (dont deux seulement sont représentées), interposées entre les première et deuxième faces 23 et 24 sur lesquelles sont ménagées les pistes 41 à 44.

Les deux couches de cuivre prises en sandwich entre les trois couches dites de substrat 32 forment des plaques de masse électrique 31, aussi appelée plans de masse.

Le circuit imprimé 8 présente une première paire de pistes 41a-b, une deuxième paire de pistes 42a-b, une troisième paire de pistes 43a-b et une quatrième paire de pistes 44a-b qui cheminent le long des première et deuxième faces 23 et 24.

Le circuit imprimé 8 présente, sur son premier côté 20, une première paire de bornes de connexion 51a-b en entrée du circuit 8 et une deuxième paire de bornes de connexion 52a-b en entrée du circuit 8, qui sont ménagées sur la première face 23 du circuit 8, ainsi qu'une troisième paire de bornes de connexion 53a-b en entrée du circuit 8 et une quatrième paire de bornes de connexion 54a-b en entrée du circuit 8, qui sont ménagées sur la deuxième face 24 du circuit 8.

Le circuit imprimé 8 présente également, sur son premier côté 20, un premier plan de cuivre 71 disposé en regard de la première paire de bornes de connexion 51a-b ; un deuxième plan de cuivre 72 disposé en regard de la deuxième paire de bornes de connexion 52a-b ; un troisième plan de cuivre 73 disposé en regard de la troisième paire de bornes de connexion 53a-b ; et un quatrième plan de cuivre 74 disposé en regard de la quatrième paire de bornes de connexion 54a-b.

Chacun des plan de cuivre 71 à 74 est ici équipé de deux vias configurés chacun pour établir une liaison électrique équipotentielle entre les plans de masse 31.

Le circuit imprimé 8 présente, sur son deuxième côté 21, une première paire de bornes de connexion 61a-b en sortie du circuit 8, une deuxième paire de bornes de connexion 62a-b en sortie du circuit 8, une troisième paire de bornes de connexion 63a-b en sortie du circuit 8 et une quatrième paire de bornes de connexion 64a-b en sortie du circuit 8.

Chaque borne de connexion de sortie est ménagée au travers du circuit 8 et débouche à la fois sur les première et deuxième faces 23 et 24 du circuit 8.

Les bornes de connexion d'entrée 51-54 sont ici alignées, par paire, sur les faces respectives 23-24 du circuit 8 tandis que les bornes de connexion de sortie 61-64 sont disposées sur deux rangées, l'une des rangées ayant six bornes de connexion de sortie 61 a-b, 62a-b et 64a-b et l'autre rangée ayant les deux bornes restantes de connexion de sortie 63a-b.

La première paire de bornes de connexion d'entrée 51a-b est ici reliée directement à la première paire de bornes de connexion de sortie 61a-b par l'intermédiaire de la première paire de pistes 41a-b, lesquelles pistes comportent chacune une unique portion qui chemine de manière continue uniquement sur la première face 23 du circuit 8.

La deuxième paire de bornes de connexion d'entrée 52a-b est ici reliée directement à la deuxième paire de bornes de connexion de sortie 62a-b par l'intermédiaire de la deuxième paire de pistes 42a-b, lesquelles pistes comportent chacune une unique portion qui chemine de manière continue uniquement sur la première face 23 du circuit 8.

La troisième paire de bornes de connexion d'entrée 53a-b est ici reliée directement à la troisième paire de bornes de connexion de sortie 63a-b par l'intermédiaire de la troisième paire de pistes 43a-b, lesquelles pistes comportent chacune une unique portion qui chemine de manière continue uniquement sur la deuxième face 24 du circuit 8.

La quatrième paire de bornes de connexion d'entrée 54a-b est ici reliée indirectement à la quatrième paire de bornes de connexion de sortie 64a-b par l'intermédiaire de la quatrième paire de pistes 44a-b, lesquelles pistes comportent chacune une première portion, respectivement 45a et 45b, qui chemine sur la deuxième face 24 du circuit 8 ainsi qu'une deuxième portion, respectivement 46a et 46b, qui chemine sur la première face 23 du circuit 8.

Les premières et deuxièmes portions respectives des pistes 44a et 44b sont reliées par des portions de transition 47 qui traversent les plaques de masse électrique 31 du circuit 8 pour rejoindre l'une ou l'autre des faces 23 et 24 du circuit 8. Ces portions de transition sont ici formées par des vias de transition 47 qui sont des trous métallisés et donc des conducteurs électriques.

Le circuit imprimé 8 comporte en outre une pluralité de vias d'interconnexion 35 logés à différents endroits dans le circuit 8 et qui traversent tous à la fois les première et deuxième faces 23 et 24 et les plaques de masse 31 du circuit 8. Ces vias d'interconnexion 35 sont ici formés par des trous métallisés et sont donc des conducteurs électriques passant par les plaques de masse 31.

Les vias 35 sont configurés pour maintenir une liaison équipotentielle entre les plaques de masse 31 du circuit imprimé 8, ce qui permet d'éviter la création de courants de surface différents entre chaque plaque de masse 31.

On notera que certains vias 35 sont en outre configurés pour améliorer le blindage électrique et/ou magnétique entre les paires de pistes de cheminement. Il s'agit par exemple des deux paires de vias 35 disposées du second côté 21 du circuit imprimé 8 et interposés respectivement entre la première paire de pistes 41a-b et les deuxièmes portions 46a et 46b de la quatrième paire de pistes 44a-b et entre la première paire de pistes 41 a-b et la deuxième paire de pistes 42a-b.

Le circuit imprimé 8 présente un troisième côté 33 et un quatrième côté 34 opposé au troisième côté 33, ainsi que deux encoches 36 ménagées sur chacun des troisième et quatrième côtés 33 et 34, dans la matière du circuit 8. Ces encoches 36 sont configurées pour permettre l'établissement d'une connexion électrique entre les plaques de masse 31 et le corps de prise 18.

Le circuit imprimé 8 comporte en outre une fente centrale traversante 38 s'étendant longitudinalement dans le circuit 8 et débouchant sur le premier côté 20 du circuit 8. La fente 38 traverse à la fois les première et deuxième faces 23 et 24 et les plaques de masse 31 du circuit 8 et est configurée pour recevoir la paroi centrale 28 de l'épanouisseur 9.

Le circuit imprimé 8 comporte en outre un plot de connexion 37 logé au bout de la fente 38 et débouchant au niveau de chacune des première et deuxième faces 23 et 24. Le plot de connexion 37 est équipé de vias (non représentés) qui sont configurés pour minimiser le couplage électrique et/ou magnétique entre les paires de pistes de cheminement 41 à 44.

Les figures 6 et 7 montrent en détail l'épanouisseur 9 selon différents angles de vue.

L'épanouisseur 9 présente une forme générale longitudinale s'étendant entre une première extrémité 210, de laquelle s'étend le corps séparateur 25, et une deuxième extrémité 211, opposée à la première extrémité 210, jusqu'à laquelle s'étend le corps d'extension 26 en saillie du corps séparateur 25.

On observera que l'épanouisseur 9 présente ici deux axes de symétrie, orthogonaux, s'étendant longitudinalement le long de l'épanouisseur 9 de sorte que ce dernier présente une partie supérieure et une partie inférieure qui est l'image miroir de la partie supérieure ainsi qu'une première partie latérale et une deuxième partie latérale qui est également l'image miroir de la première partie latérale.

Le corps séparateur 25 comporte ici une base métallique en forme de croix ayant une paroi centrale 212 et deux parois latérales 213 disposées de part et d'autre de la paroi centrale 212. Sur les figures 6 et 7, la paroi centrale 212 est verticale tandis que les parois latérales 213 sont horizontales.

Chaque paroi latérale 213 présente une première portion 214 qui est plane, une deuxième portion 215 s'étendant à partir de la première portion 214 et qui est sensiblement conique, ainsi qu'une troisième portion 216 s'étendant à partir de la deuxième portion 215, au niveau de son extrémité la plus évasée, et qui est plane.

La deuxième portion conique 215 est pourvue de bossages latéraux 217 et la troisième portion 216 a une forme sensiblement en C pourvue de deux premières pattes d'accroche 218 sur lesquelles sont également ménagés des bossages latéraux 275.

La paroi centrale 28 du corps d'extension 26 est ici métallique et s'étend dans le prolongement de la paroi centrale 212 du corps séparateur 25.

L'épanouisseur 9 présente un bord supérieur 219 longeant des extrémités supérieures respectives des parois centrales 212 et 28 et trois protubérances 220, 221 et 222, dites supérieures, s'étendant en saillie de ce bord supérieur 219.

L'épanouisseur 9 présente en outre un bord inférieur (non représenté) longeant des extrémités inférieures respectives des parois centrales 212 et 28 et trois protubérances identiques à celles mentionnées ci-dessus, dites inférieures, et dont seulement une est visible sur les figures, s'étendant en saillie du bord inférieur.

La protubérance 220 est ménagée sur la paroi centrale 212, la protubérance 222 est ménagée sur la paroi centrale 28 et la protubérance 221 est ménagée à cheval sur les parois centrales 212 et 28.

Le corps d'extension 26 comporte deux pièces de positionnement 223 ici sensiblement en forme de L, montées chacune sur la paroi centrale 28 à la deuxième extrémité 211 de l'épanouisseur 9 et de part et d'autre de l'évidement 27 ménagé dans le corps d'extension 26.

Chaque pièce de positionnement 223 est ici métallique et présente une première branche 224 du L dans laquelle sont ménagées deux encoches 225, ainsi qu'une deuxième branche 226 du L s'étendant à partir de la première branche 224 vers le corps séparateur 25.

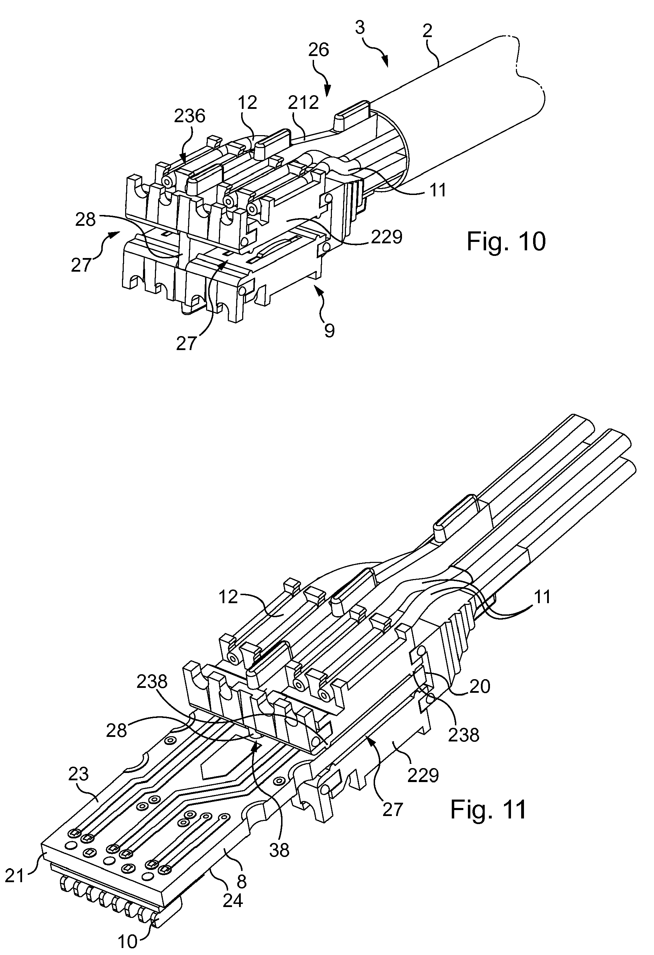

On notera que les encoches 25 sont prévues pour le positionnement initial des paires de fils lorsque ces dernières sont montées sur l'épanouisseur 9 (voir ci-après plus en détail). Une fois les fils en place, ces derniers sont coupés au niveau de leur extrémité libre respective (voir les figures 10 et 11).

La deuxième branche du L forme ici une deuxième patte d'accroche 226 disposée de part et d'autre de la paroi centrale 28 du corps d'extension.

La première branche 224 présente en outre une face externe 228 du côté opposée au côté duquel s'étend la deuxième branche, face externe 228 sur laquelle sont ménagées trois surfaces d'appui 227.

Chaque surface d'appui 227 est ici formée entre deux encoches 225 successives.

On observera que le corps séparateur 25 et le corps d'extension 26 sont configurés pour que chaque première patte d'accroche 218 soit située en regard et à distance d'une deuxième patte d'accroche respective 226.

Chaque pièce de positionnement 223 est en outre pourvue de bossages latéraux 276, similaires aux bossages latéraux 275 ménagés sur la troisième portion 216 de chaque paroi latérale 213, et situés à la jonction des première et deuxième branches du L.

Le corps d'extension 26 comporte en outre des systèmes de contact auto-dénudant 229 disposés chacun dans l'espace ménagé entre des première et deuxième pattes d'accroches respectives 218 et 226.

Chaque système de contact auto-dénudant 229 comporte deux organes de contact auto-dénudant 230 qui sont métalliques, et un corps moulé 231 qui est réalisé en matière plastique et dans lequel sont logés ces deux organes 230.

Chaque organe 230 comporte une base de contact 291 et des dents de perforation 232 qui saillent de la base de contact 291.

Chaque corps moulé 231 comporte une portion longitudinale 233 qui présente, à ses deux extrémités, deux renfoncements 234 formant ainsi deux pinces sensiblement en forme de C qui sont montées respectivement sur une première patte d'accroche 218 de la troisième portion 216 et sur une deuxième patte d'accroche 226 d'une pièce de positionnement 223.

Chaque portion longitudinale 233 présente une face de fond 237 et trois murets longitudinaux 235 situés à distance les uns des autres et s'étendant à l'opposé de la face de fond 237.

Chaque corps moulé 231 comporte en outre deux espaces d'insertion 236 ménagés chacun entre deux murets successifs 235 et s'étendant chacun transversalement dans la portion longitudinale 233 jusqu'à déboucher dans la face de fond 237.

Dans chacun des espaces d'insertion 236 est introduit un organe de contact auto-dénudant 230.

Chaque espace d'insertion 236 présente une partie formant cavité pour accueillir la base de contact 291 d'un organe 230 respectif, ainsi qu'une partie formant tunnel, entre deux murets respectifs 235, dans laquelle saillent les dents de perforation 232 respectives.

La base de contact 291 de chaque organe 230 saille de la partie formant cavité de l'espace d'insertion 236 respectif, dans l'évidement 27 ménagé dans le corps d'extension 26.

Chaque corps moulé 231 comporte en outre, à chaque extrémité de la portion longitudinale 233, une nervure 238 ménagée sur sa face de fond 237 et saillant dans l'évidement 27 ménagé dans le corps d'extension 26.

Dans l'épanouisseur 9, huit organes 230 sont ainsi disposés, deux à deux, de part et d'autre de la paroi centrale 28 et de part et d'autre de l'évidement 27 du corps d'extension 26, dans le prolongement des faces supérieures et inférieures des deux portions latérales 213 du corps séparateur 25.

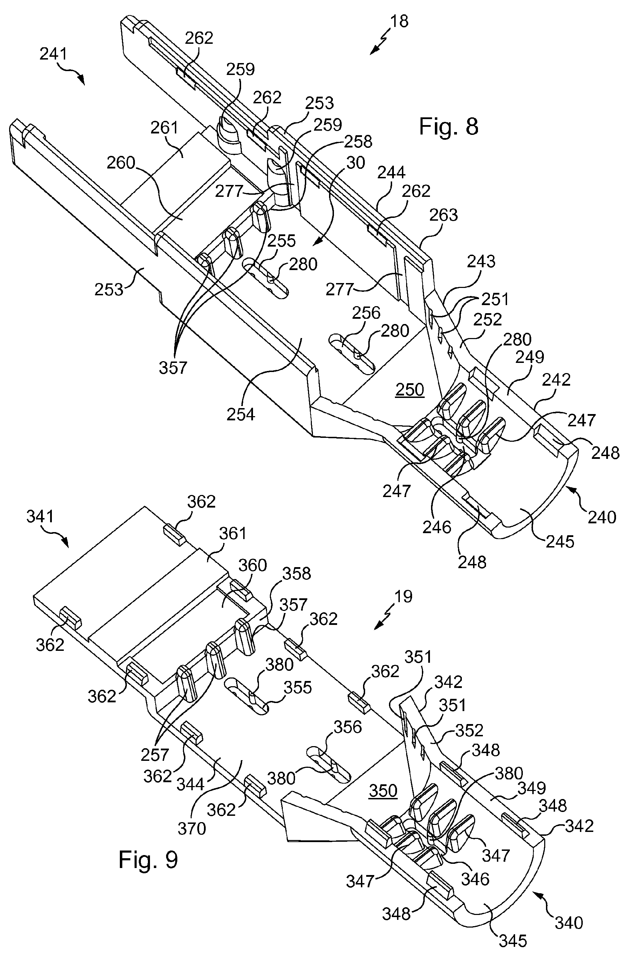

Les figures 8 et 9 montrent en détail le corps de prise 18 et le capot de prise 19 formant une enveloppe métallique que comporte la première prise mâle 5.

Le corps de prise 18 a globalement une forme de U et présente une première extrémité 240 et une deuxième extrémité 241 opposée à la première extrémité 240.

Le corps de prise 18 comporte une première portion 242 s'étendant à partir de la première extrémité 240 et qui est sensiblement cylindrique, une deuxième portion 243 s'étendant à partir de la première portion 242 et qui est sensiblement tronconique, une troisième portion 244 s'étendant à partir de la partie la plus évasée de la deuxième portion 243 jusqu'à la deuxième extrémité 241, et qui est en U.

La première portion cylindrique 242 présente une face interne 245 sur laquelle est ménagée, en renfoncement, une cavité 246 qui est configurée pour recevoir la protubérance 220 dite supérieure de l'épanouisseur 9 ; de sorte à établir une liaison électrique entre le corps de prise 18 et l'épanouisseur 9. Dans cette cavité 246 sont formées de petites nervures 280.

La première portion cylindrique 242 comporte des organes de maintien 247 formés en saillie sur sa face interne 245 et configurés pour maintenir les fils conducteurs en position sur le corps séparateur 25 de l'épanouisseur 9.

La première portion cylindrique 242 présente en outre un bord 249 et des encoches d'assemblage 248 formées en renfoncement dans ce bord 249.

La deuxième portion tronconique 243 présente une face interne 250 sur laquelle sont ménagées, en renfoncement, des rainures 251 à proximité d'un bord 252 et qui sont configurées pour coopérer avec les bossages 217 du corps séparateur 25 de l'épanouisseur 9 ; de sorte à établir une liaison électrique entre le corps de prise 18 et l'épanouisseur 9.

La troisième portion en U 244 est pourvue de deux parois latérales 253 en regard l'une de l'autre et d'une paroi de fond 254 raccordant les deux parois latérales 253, ces parois définissant globalement l'espace interne 30 du corps de prise 18.

La troisième portion 244 présente deux rainures 277 formées dans chaque paroi latérale 253 et configurées pour recevoir des bossages latéraux 275 et 276 formés respectivement sur le corps séparateur 25 et sur le corps d'extension 26 ; de sorte à établir une liaison électrique entre le corps de prise 18 et l'épanouisseur 9.

La troisième portion 244 comporte deux cavités 255 et 256 ménagées chacune en renfoncement dans la paroi de fond 254, du côté de l'espace interne 30, et qui sont configurées pour recevoir respectivement les protubérances 222 et 223 de l'épanouisseur 9 ; de sorte à établir une liaison électrique entre le corps de prise 18 et l'épanouisseur 9. Dans ces cavités 255 et 256 sont formées de petites nervures 280.

La troisième portion 244 comporte des organes de contact et de positionnement 257 s'étendant de la paroi de fond 254 en saillie dans l'espace interne 30 et configurés pour venir en appui sur les surfaces d'appui 227 respectives d'une pièce de positionnement 223 respective ; de sorte à établir une liaison électrique entre le corps de prise 18 et l'épanouisseur 9.

Les organes de contact et de positionnement 257 sont formés à cheval sur un épaulement 258 que comporte la paroi de fond 254.

La troisième portion 244 comporte des plots de contact 259, chacun ménagés à la fois sur la paroi de fond 254 et sur les parois latérales 253, en saillie dans l'espace interne 30.

Ces plots de contact 259 sont configurés pour coopérer avec les encoches 36 du circuit imprimé 8 de sorte à établir une liaison électrique entre les plaques de masse 31 de ce circuit 8 et le corps de prise 18.

Deux plots de contact 259 sont disposés à cheval sur l'épaulement 258 et deux autres plots de contact 259 sont disposés entre cet épaulement 258 et la deuxième extrémité 241 du corps de prise 18.

La troisième portion 244 comporte, sur sa paroi de fond 254, une portion en renfoncement 260 ménagée entre l'épaulement 258 et la deuxième extrémité 241 du corps de prise 18, ainsi qu'une portion en élévation 261 ménagée entre la portion en renfoncement 260 et cette deuxième extrémité 241.

Les parois latérales 253 de la troisième portion 244 présentent chacune un bord 263 et des encoches d'assemblage 262 formées en renfoncement dans les bords 263 respectifs.

Les encoches d'assemblage 248 et 262 forment ici des organes d'assemblage du corps de prise 18.

Le capot de prise 19 est configuré pour être assemblé avec le corps de prise 18 et présente une forme relativement similaire à ce dernier.

Le capot de prise 19 présente une première extrémité 340 et une deuxième extrémité 341 opposée à la première extrémité 340.

Le capot de prise 19 comporte une première portion 342 s'étendant à partir de la première extrémité 340 et qui est sensiblement cylindrique, une deuxième portion 343 s'étendant à partir de la première portion 342 et qui est sensiblement tronconique, une troisième portion 344 s'étendant à partir de la partie la plus évasée de la deuxième portion 343 jusqu'à la deuxième extrémité 341, et qui est sensiblement plane.

La première portion cylindrique 342 présente une face interne 345 sur laquelle est ménagée, en renfoncement, une cavité 346 qui est configurée pour recevoir une protubérance 220 dite inférieure de l'épanouisseur 9 ; de sorte à établir une liaison électrique entre le capot de prise 19 et l'épanouisseur 9. Dans cette cavité 346 sont formées de petites nervures 380.

La première portion cylindrique 342 comporte des organes de maintien 347 formés en saillie sur sa face interne 345 et configurés pour maintenir les fils conducteurs en position sur le corps séparateur 25 de l'épanouisseur 9.

La première portion cylindrique 342 présente en outre un bord 349 et des plots d'assemblage 348 formés en saillie de ce bord 349, et qui sont configurés pour être reçus dans les encoches d'assemblage 248 du corps de prise 18 ; de sorte à établir une liaison électrique entre le capot de prise 19 et le corps de prise 18.

La deuxième portion tronconique 343 présente une face interne 350 sur laquelle sont ménagées, en renfoncement, des rainures 351 à proximité d'un bord 352, lesquelles rainures sont configurées pour coopérer avec les bossages 217 du corps séparateur 25 de l'épanouisseur 9 ; de sorte à établir une liaison électrique entre le capot de prise 19 et l'épanouisseur 9.

La troisième portion plane 344 présente une face interne 370 dans laquelle sont ménagées, en renfoncement, deux cavités 355 et 356 qui sont configurées pour recevoir respectivement des protubérances dites inférieures de l'épanouisseur 9 ; de sorte à établir une liaison électrique entre le capot de prise 19 et l'épanouisseur 9. Dans ces cavités 355 et 356 sont formées de petites nervures 380.

La troisième portion plane 344 comporte des organes de contact et de positionnement 357 s'étendant en saillie de la face interne 370 et configurés pour venir en appui sur les surfaces d'appui 227 respectives d'une pièce de positionnement 223 respective ; de sorte à établir une liaison électrique entre le capot de prise 19 et l'épanouisseur 9.

Les organes de contact et de positionnement 357 sont formés à cheval sur un épaulement 358 que comporte la troisième portion plane 344.

La troisième portion plane 344 comporte sur ses côtés des plots d'assemblage 362 en saillie de la face interne 370, et qui sont configurés pour être reçus dans les encoches d'assemblages 262 du corps de prise 18 ; de sorte à établir une liaison électrique entre le corps de prise 18 et le capot de prise 19.

Les plots d'assemblage 348 et 362 forment ici des organes d'assemblage complémentaires du capot de prise 19.

La troisième portion plane 344 comporte en outre une portion en renfoncement 360 ménagée entre l'épaulement 358 et la deuxième extrémité 341 du capot de prise 19, ainsi qu'une portion en élévation 361 ménagée entre la portion en renfoncement 360 et cette deuxième extrémité 341.

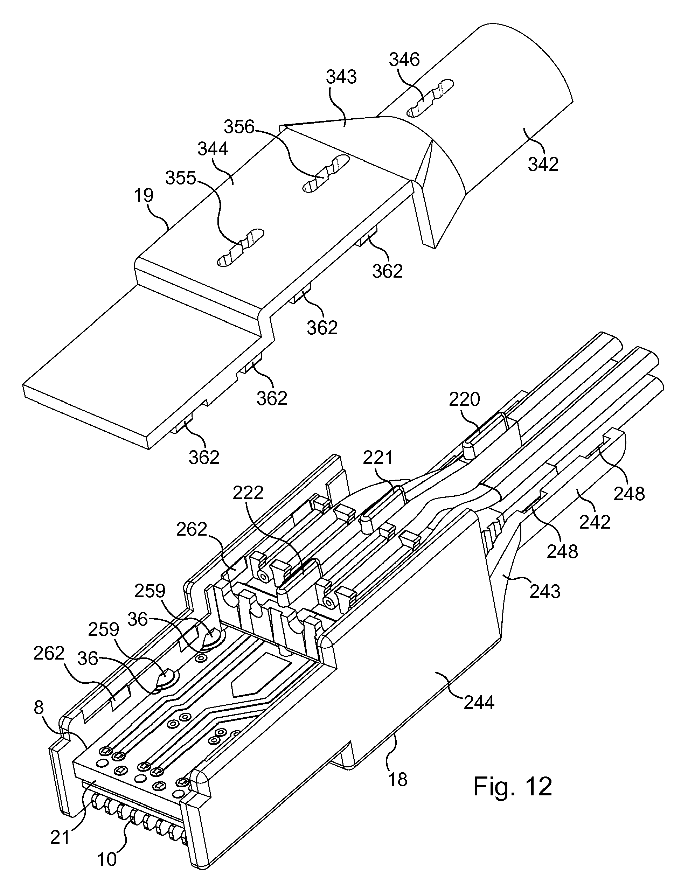

On va maintenant décrire le procédé d'assemblage de la prise mâle 5 en référence aux figures 10 à 13. Un procédé similaire s'applique bien entendu à la prise mâle 6.

Les paires de fils 11 à 14 à l'extrémité 3 du câble 2 sont fixées sur l'épanouisseur 9 pour former un premier sous-ensemble de connexion (figure 10). L'épanouisseur 9 est placé en contact direct contre la gaine 15 du câble 2.

Les paires de fils 11 à 14 sont séparées les unes des autres, sans croisement, par le corps séparateur 25, et plus précisément par la paroi centrale 212 et les parois latérales 213, puis emmenés vers un corps moulé 231 respectif du corps d'extension 26.

Chaque fil des paires de fils 11 à 14 est introduit dans la partie en tunnel d'un espace d'insertion 236 respectif d'un système de contact auto-dénudant 229 respectif jusqu'aux encoches 225.

Chaque fil conducteur est ainsi mis en contact avec un organe 230 respectif par perforation de la gaine isolante enveloppant ce fil par les dents 232 respectives, puis chaque fil est coupé à longueur, entre l'encoche 225 respective et la sortie de la partie en tunnel respective.

Un second sous-ensemble formé du circuit imprimé 8 et des plaquettes de contact 10 fixées sur ce dernier est ici monté sur le premier sous-ensemble de connexion pour former un premier ensemble de connexion (figure 11).

Plus précisément, ce second sous-ensemble est partiellement introduit dans l'évidement 27 de l'épanouisseur 9, par le premier côté 20 du circuit 8 où la fente 38 est formée.

La paroi centrale 28 du corps d'extension 26 est ainsi introduite dans la fente 38 jusqu'à venir en butée contre le fond de la fente 38.

La paroi centrale 28 et la fente 38 sont configurées pour que les côtés de la paroi centrale 28 soient guidés par la paroi délimitant la fente 38.

Le corps d'extension 26 et le circuit 8 sont configurés pour que ce dernier ait ses première et deuxième faces 23 et 24 partiellement en regard des faces internes respectives des systèmes de contact auto-dénudant 229 respectifs.

Les première et deuxième faces 23 et 24 du circuit 8 viennent en outre en appui contre les nervures 238 des corps moulés 231 respectifs et le circuit 8 est guidé par ces dernières.

Les bornes de connexion en entrée 51 à 54 du circuit 8 sont en contact mécanique et électrique avec les portions des bases de contact 291 respectives qui saillent dans l'évidement 27, connectant ainsi électriquement ces bornes d'entrée 51 à 54 aux paires de fils 11 à 14.

Le premier ensemble de connexion est ensuite introduit partiellement dans l'espace interne 30 du corps de prise 18, de haut en bas, c'est-à-dire à partir du bord 262 des parois latérales 253 en direction de la paroi de fond 254 de la troisième portion 244 de ce corps de prise 18.

Les protubérances inférieures (non représentées) de l'épanouisseur 9 qui saillent des extrémités inférieures de ses parois centrales 212 et 28 sont reçues partiellement dans les cavités 246, 255 et 256 du corps de prise 18 ; de sorte à établir un contact électrique entre l'épanouisseur 9 et le corps de prise 18.

Le premier ensemble de connexion est positionné et maintenu dans le corps de prise 18 par la coopération des protubérances inférieures avec les nervures 280 formées dans ces cavités 246, 255 et 256 et avec les organes de maintien 347 du corps de prise 18.

Les encoches 36 ménagées sur chacun des troisième et quatrième côtés 33 et 34 du circuit 8 sont montées sur les plots de contact 259 du corps de prise 18 ; de sorte à établir un contact électrique entre le circuit 8 et le corps de prise 18.

Les rainures 251 de la deuxième portion tronconique 243 coopèrent avec les bossages latéraux 217 du corps séparateur 25 de l'épanouisseur 9 ; de sorte à établir un contact électrique entre l'épanouisseur 9 et le corps de prise 18.

Les rainures 277 de la troisième portion 244 coopèrent avec les bossages latéraux 275 et 276 de corps séparateur 25 et du corps d'extension 26 de l'épanouisseur 9 ; de sorte à établir un contact électrique entre l'épanouisseur 9 et le corps de prise 18.

Les organes de contact et de positionnement 257 de la troisième portion 244 viennent en appui sur les surfaces d'appui 227 respectives des pièces de positionnement 223 ; de sorte à établir un contact électrique entre l'épanouisseur 9 et le corps de prise 18.

On observera que le corps de contact 16 est normalement monté sur les plaquettes de contacts 10 et partiellement sur le circuit 8 avant insertion de ceux-ci dans le corps de prise 18.

Le corps de contact 16 est configuré pour venir reposer sur la portion en renfoncement 260 et sur la portion en élévation 261 que comporte la troisième portion 244 du corps de prise 18.

Ainsi, la première portion 242 du corps de prise 18 reçoit partiellement une première partie de la paroi centrale 212 et les premières portions 214 respectives des parois latérales 213 du corps séparateur 25.

La deuxième portion 243 du corps de prise 18 reçoit partiellement une deuxième partie de la paroi centrale 212 et les deuxièmes portions 215 respectives de ces parois latérales 213.

La troisième portion 244 du corps de prise 18 reçoit complétement l'épanouisseur 9 et le second sous-ensemble de connexion formé du circuit imprimé 8 et des plaquettes de contact 10, ainsi que partiellement le corps de contact 16.

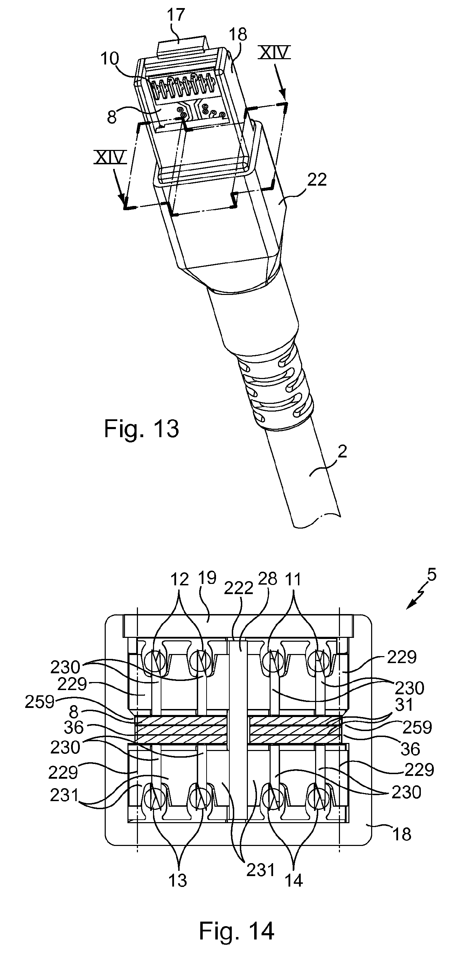

La troisième portion 244 est configurée pour que les plaquettes de contact 10 soient accessibles (figure 13).

Le capot de prise 19 est monté sur le corps de prise 18, les plots d'assemblage 348 et 362 du capot de prise 19 étant reçus dans les encoches d'assemblage 248 et 262 du corps de prise 18 ; de sorte à établir un contact électrique entre le capot de prise 19 et le corps de prise 18.

Les protubérances supérieures 220, 221 et 222 de l'épanouisseur 9 qui saillent des extrémités supérieures de ses parois centrales 212 et 28 sont reçues partiellement dans les cavités 346, 356 et 355 respectives du capot de prise 19 ; de sorte à établir un contact électrique entre l'épanouisseur 9 et le capot de prise 19.

Les rainures 351 de la deuxième portion tronconique 343 coopèrent avec les bossages 217 du corps séparateur 25 de l'épanouisseur 9 ; de sorte à établir un contact électrique entre l'épanouisseur 9 et le capot de prise 19.

Les organes de contact et de positionnement 357 de la troisième portion 344 viennent en appui sur les surfaces d'appui 227 respectives des pièces de positionnement 223 ; de sorte à établir un contact électrique entre l'épanouisseur 9 et le capot de prise 19.

On observera que la pièce d'encliquetage 17 est normalement montée sur le circuit 8 avant l'assemblage du capot de prise 19 sur le corps de prise 18.

La pièce d'encliquetage 17 est configurée pour que la portion en renfoncement 360 et la portion en élévation 361 que comporte la troisième portion 344 du capot de prise 19 viennent reposer sur cette pièce d'encliquetage 17.

La patte déformable de la pièce d'encliquetage 17 est configurée pour rester en dehors de l'enveloppe métallique formée du corps de prise 18 et du capot de prise 19.

Ainsi, la première portion 342 du capot de prise 19 recouvre partiellement la première partie de la paroi centrale 212 et les premières portions 214 respectives des parois latérales 213 du corps séparateur 25.

La deuxième portion 343 du capot de prise 19 recouvre partiellement la deuxième partie de la paroi centrale 212 et les deuxièmes portions 215 respectives de ces parois latérales 213.

La troisième portion 344 du capot de prise 19 recouvre complétement l'épanouisseur 9 et le second sous-ensemble de connexion formé du circuit imprimé 8 et des plaquettes de contact 10, ainsi que partiellement la pièce d'encliquetage 17.

Le manchon 22 est ensuite monté sur le câble 2 et vient recouvrir une majeure partie de l'enveloppe métallique, la languette déformable 29 du manchon 22 venant en appui sur la patte déformable de la pièce d'encliquetage 17.

Le manchon 22 enveloppe le corps de prise 18 et le capot de prise 19 à partir de leur première extrémité respective 240, 340 jusqu'à leur épaulement respectif 258, 358 formé dans leur troisième portion respective 244, 344 ; ce qui correspond globalement à l'endroit où se situe la deuxième extrémité 211 de l'épanouisseur 9 dans l'enveloppe métallique.

La figure 14 illustre schématiquement une coupe transversale de la prise mâle 5 assemblée.

Les plaques de masse 31 du circuit 8 sont connectées électriquement au corps de prise 18 par l'intermédiaire des encoches 36 et des plots de contact 259.

L'épanouisseur 9 est connecté électriquement aux corps et capot de prise 18 et 19 par l'intermédiaire des cavités 246, 255, 256, 346, 355 et 356 et des protubérances supérieures et inférieures, par l'intermédiaire des bossages latéraux 217, 275 et 276 et des rainures 251, 351 et 277, et par l'intermédiaire des surfaces d'appui 227 et des organes de contact et de positionnement 257 et 357.

Les corps et capot de prise 18 et 19 sont connectés électriquement entre eux par l'intermédiaire de leurs bords respectifs 249, 252, 263, 342 et 352 et aussi des plots d'assemblage 348 et 362 et des encoches d'assemblage 248 et 262.

Ainsi, à la fois le corps de prise 18, le capot de prise 19, les plaques de masse 31 du circuit 8 et la paroi centrale de blindage 28 sont connectés électriquement ensemble à un potentiel de référence, et sont configurés pour former des cages individuelles de blindage électrique et/ou magnétique, ménagées autour de chaque paires de fils 11 à 14, aussi appelées « cages de Faraday » ; tandis que chaque fil conducteur est isolé électriquement des autres (y compris celui de la même paire) grâce au corps moulé 231 respectif du système de contact auto-dénudant respectif 229 dans lequel est reçu chaque fil conducteur.

Dans des variantes non illustrées :
- le circuit imprimé ne présente pas trois couches de substrat et quatre couches de cuivre mais par exemple deux couches de substrats et trois couches de cuivre, dont une seule forme un plan de masse pris en sandwich entre les deux couches de substrat ;
- le circuit imprimé présente des pistes de cheminements distinctes de celles illustrées sur les figures et par exemple, plusieurs voire toute les pistes cheminent de manière discontinue, ou continue, sur les deux faces du circuit ;
- le circuit imprimé présente plus ou moins de vias de connexion et/ou ils sont ménagés selon un agencement différent de celui illustré sur les figures 3 et 4 ;
- le circuit imprimé présente une fente plus ou moins longue pourvu qu'une majeure partie de la paroi centrale du corps d'extension de l'épanouisseur puisse y être introduite ;
- la ou les plaques de masse sont également connectées électriquement à la paroi centrale du corps d'extension de l'épanouisseur par l'intermédiaire de point de contacts dans la fente du circuit, voire par l'intermédiaire du plot de contact formé dans le circuit au bout de la fente ;
- le circuit imprimé présente plus ou moins d'encoches sur ses troisième et quatrième côtés ; et/ou
- la pièce d'encliquetage est montée sur le circuit imprimé avant l'insertion de ce dernier dans le corps de prise.

On rappelle plus généralement que l'invention ne se limite pas aux exemples décrits et représentés.

## Revendications

1. Prise RJ45 mâle pour cordon de raccordement électrique RJ45 pourvu d'un câble (2) ayant quatre paires de fils conducteurs (11-14) configurées pour être connectées électriquement à ladite prise mâle (5, 6), laquelle comporte un circuit imprimé (8) présentant une première face (23) et une deuxième face (24) opposée à ladite première face (23), ainsi qu'une pluralité de pistes de cheminement électrique (41-46) auxquelles lesdites paires de fils conducteurs (11-14) sont configurées pour être connectées électriquement, un système d'épanouissement (9) monté sur ledit circuit imprimé (8) et configuré pour séparer, isoler électriquement et blinder électriquement lesdites paires de fils conducteurs (11-14) les unes des autres ; ladite prise mâle (5, 6) étant **caractérisée en ce que** :
- ledit circuit imprimé (8) comporte au moins une plaque de masse (31) prise en sandwich entre ses première et deuxième faces (23, 24) et une fente centrale traversante (38) s'étendant longitudinalement dans ledit circuit imprimé (8) et débouchant sur un côté (20) dudit circuit imprimé (8), ladite fente centrale traversante (38) étant configurée pour traverser à la fois lesdites première et deuxième faces (23, 24) et ladite au moins une plaque de masse électrique (31) ;
- ledit système d'épanouissement (9) comporte un corps séparateur (25) et un corps d'extension (26) en saillie dudit corps séparateur (25), ledit corps d'extension (26) étant pourvu d'un évidement (27) configuré pour recevoir ledit circuit imprimé (8) et d'une paroi centrale de blindage électrique et/ou magnétique (28) divisant ledit évidement (27) en deux parties et étant configurée pour s'insérer au moins en majeure partie dans ladite fente centrale traversante (38) dudit circuit imprimé (8) ;
et ladite paroi centrale de blindage électrique et/ou magnétique (28) et ladite au moins une plaque de masse (31) dudit circuit imprimé (8) sont configurées pour être interconnectées électriquement et ainsi former une barrière de blindage électrique et/ou magnétique entre chaque paire de fils conducteurs (11-14).

2. Prise RJ45 mâle selon la revendication 1, **caractérisée en ce qu'**elle comporte en outre une enveloppe métallique configurée pour envelopper au moins partiellement ledit circuit imprimé (8), et ladite paroi centrale de blindage électrique et/ou magnétique (28), ladite au moins une plaque de masse (31) et ladite enveloppe métallique sont configurées pour être interconnectées électriquement et ainsi former sensiblement une cage individuelle de blindage électrique et/ou magnétique autour de chaque paire de fils conducteurs (11-14).

3. Prise RJ45 mâle selon la revendication 2, **caractérisée en ce que** ladite paroi centrale de blindage électrique et/ou magnétique (28) est pourvue d'une extrémité supérieure et d'une extrémité inférieure opposée à ladite extrémité supérieure, et d'au moins une protubérance (221, 222) ménagée en saillie d'au moins une dite extrémité supérieure et/ou inférieure et configurée pour être au moins partiellement reçue dans au moins une cavité (255, 256, 355, 356) ménagée dans ladite enveloppe métallique.

4. Prise RJ45 mâle selon l'une des revendications 2 et 3, **caractérisée en ce qu'**elle comporte en outre des plaquettes de contact (10) configurées pour être fixées sur ledit circuit imprimé (8) et un corps de contact (16) configuré pour être monté sur lesdites plaquettes de contact (10), et ladite enveloppe métallique est pourvue d'une portion en renfoncement (360) et/ou d'une portion en élévation (361) contre laquelle est positionné ledit corps de contact (16).

5. Prise RJ45 mâle selon l'une des revendications 2 et 3, **caractérisée en ce qu'**elle comporte en outre une pièce d'encliquetage (17) configurée pour immobiliser ladite prise mâle (5, 6) dans une prise femelle dans laquelle ladite prise mâle (5, 6) est configurée pour être montée, et ladite enveloppe métallique est pourvue d'une portion en renfoncement (260) et/ou d'une portion en élévation (261) contre laquelle est positionnée ladite pièce d'encliquetage (17).

6. Prise RJ45 mâle selon l'une quelconque des revendications 2 à 5, **caractérisée en ce que** ladite enveloppe métallique est formée en deux parties, respectivement un corps de prise (18) configuré pour recevoir ledit circuit imprimé (8) et ledit système d'épanouissement (9), ainsi qu'un capot de prise (19) configuré pour être monté sur ledit corps de prise (18) et pour recouvrir ledit circuit imprimé (8) et ledit système d'épanouissement (9).

7. Prise RJ45 mâle selon l'une quelconque des revendications 2 à 6, **caractérisée en ce que** ledit circuit imprimé (8) est pourvu d'au moins une encoche (36) ménagée sur au moins un côté (33, 34) dudit circuit imprimé (8) et ladite enveloppe métallique est pourvue d'au moins un plot de contact (259) configuré pour coopérer avec ladite au moins une encoche (36) de sorte à établir une liaison électrique entre ladite au moins une plaque de masse (31) et ladite enveloppe métallique.

8. Prise RJ45 mâle selon l'une quelconque des revendications 2 à 7, **caractérisée en ce que** ledit système d'épanouissement (9) comporte en outre des systèmes de contact auto-dénudant (229) configurés pour établir une connexion électrique entre lesdites paires de fils conducteurs (11-14) et lesdites pistes de cheminement électrique (41-46) dudit circuit imprimé (8), chaque système de contact auto-dénudant (229) étant pourvu de deux organes de contact auto-dénudant (230) et d'un corps moulé (231) configuré pour recevoir au moins partiellement et isoler électriquement l'un de l'autre lesdits organes de contact auto-dénudant (230), ledit corps d'extension (26) dudit système d'épanouissement (9) comporte deux pièces de positionnement (223) montées sur ladite paroi centrale (28) de part et d'autre dudit évidement (27), et chaque corps moulé (231) est fixé à la fois sur une dite pièce de positionnement (223) respective et sur ledit corps séparateur (25).

9. Prise RJ45 mâle selon la revendication 8, **caractérisée en ce qu'**au moins une dite pièce de positionnement (223) présente une face externe (228) sur laquelle est ménagée au moins une surface d'appui (227) et ladite enveloppe métallique est pourvue d'au moins un organe de contact et de positionnement (257, 357) configuré pour venir en appui sur ladite au moins une surface d'appui (227) ; et/ou au moins une dite pièce de positionnement (223) présente des bossages latéraux (276) et ladite enveloppe métallique présente au moins une face interne (250) pourvue de rainures (277) qui sont configurées pour coopérer avec lesdits bossages latéraux (276).

10. Prise RJ45 mâle selon l'une des revendications 8 et 9, **caractérisée en ce que** chaque corps moulé (231) est pourvu d'une face de fond (237) tournée vers ledit évidement (27), de trois murets longitudinaux (235) situés à distance les uns des autres et s'étendant à l'opposé de ladite face de fond (237), de deux espaces d'insertion (236) ménagés chacun entre deux murets successifs (235) et s'étendant chacun transversalement dans ledit corps moulé (231) jusqu'à déboucher dans ladite face de fond (237), et chaque organe de contact auto-dénudant (230) est introduit dans un dit espace insertion (236) respectif et saille de part et d'autre de cet espace.

11. Prise RJ45 mâle selon l'une quelconque des revendications 8 à 10, **caractérisée en ce que** chaque corps moulé (231) est pourvu d'une face de fond (237) et d'au moins une nervure (238) ménagée sur ladite face de fond (237) et saillant dans ledit évidement (27) ménagé dans ledit corps d'extension (26), ladite au moins une nervure (238) étant configurée pour guider ledit circuit imprimé (8) dans ledit évidement (27).

12. Prise RJ45 mâle selon l'une quelconque des revendications 8 à 11, caractérisée en ce ledit corps séparateur (25) est pourvu de premières pattes d'accroche (218) s'étendant vers une dite pièce de positionnement (223) respective, laquelle est pourvue d'au moins une deuxième patte d'accroche (226) s'étendant en regard d'une dite première patte d'accroche (218) respective, et chaque corps moulé (231) est pourvu de deux extrémités en forme de pince montées respectivement sur une dite première patte d'accroche (218) et sur une dite deuxième patte d'accroche (226) en regard de cette dernière.

13. Prise RJ45 mâle selon l'une quelconque des revendications 2 à 12, caractérisée en ce ledit corps séparateur (25) comporte une base métallique en forme de croix ayant une paroi centrale (212) et deux parois latérales (213) disposées de part et d'autre de la paroi centrale (212), ladite paroi centrale (212) ayant une extrémité supérieure et une extrémité inférieure opposée à ladite extrémité supérieure, et au moins une protubérance (220) ménagée en saillie d'au moins une dite extrémité supérieure et/ou inférieure et configurée pour être au moins partiellement reçue dans au moins une cavité (246, 255, 346, 355) ménagée dans ladite enveloppe métallique.

14. Prise RJ45 mâle selon l'une quelconque des revendications 2 à 13, caractérisée en ce ledit corps séparateur (25) comporte une base métallique en forme de croix ayant une paroi centrale (212) et deux parois latérales (213) disposées de part et d'autre de la paroi centrale (212) et présentant chacune une portion (215) pourvue de bossages latéraux (217, 275), et ladite enveloppe métallique présente au moins une face interne (250, 350) pourvue de rainures (251, 277, 351) qui sont configurées pour coopérer avec lesdits bossages latéraux (217, 275).

15. Cordon de raccordement RJ45 configuré pour interconnecter des équipements électroniques et/ou informatiques, comportant un câble électrique (2) ayant une première extrémité (3) et une deuxième extrémité (4) opposée à la première extrémité (3), une gaine isolante (15) et quatre paires de fils conducteurs (11-14) enveloppées dans ladite gaine (15) ; et au moins une prise RJ45 mâle (5, 6) selon l'une quelconque des revendications 1 à 14, montée sur au moins une dite première extrémité (3) et/ou deuxième extrémité (4) dudit câble (2).

## Patentansprüche

1. RJ45-Stecker für elektrisches RJ45-Anschlusskabel, das mit einem Kabel (2) mit vier Adernpaaren (11-14) versehen ist, die dazu ausgebildet sind, elektrisch mit dem Stecker (5, 6) verbunden zu werden, der eine Leiterplatte (8) mit einer ersten Seite (23) und einer der ersten Seite (23) entgegengesetzt angeordneten zweiten Seite (24) sowie mit einer Vielzahl von Leiterbahnen (41-46), mit denen die Adernpaare (11-14) elektrisch verbindbar sind, und ein Anschlussverbreiterungssystem (9) umfasst, das auf der Leiterplatte (8) montiert und dazu ausgebildet ist, die Adernpaare (11-14) voneinander zu trennen, elektrisch zu isolieren und elektrisch abzuschirmen;
wobei der Stecker (5, 6) **dadurch gekennzeichnet ist, dass**
- die Leiterplatte (8) wenigstens eine Masseplatte (31), die zwischen deren ersten und zweiten Seite (23, 24) eingefügt ist, und einen durchgehenden mittigen Spalt (38) aufweist, der in der Leiterplatte (8) längs verläuft und auf einer Seite der Leiterplatte (8) mündet, wobei der durchgehende mittige Spalt (38) dazu ausgebildet ist, sowohl die erste und die zweite Seite (23, 24) als auch die wenigstens eine Masseplatte (31) zu durchqueren;
- das Anschlussverbreiterungssystem (9) einen Trennkörper (25) und einen an dem Trennkörper (25) vorstehenden Erweiterungskörper (26) aufweist, wobei der Erweiterungskörper (26) mit einer Aussparung (27), die zur Aufnahme der Leiterplatte (8) ausgebildet ist, und einer mittigen Wand (28) zur elektrischen und/oder magnetischen Abschirmung versehen ist, die die Aussparung (27) in zwei Teile teilt und dazu ausgebildet ist, wenigstens zum überwiegenden Teil in den durchgehenden mittigen Spalt (38) der Leiterplatte (8) eingeführt zu werden;
und die mittige elektrische und/oder magnetische Abschirmwand (28) und die wenigstens eine Masseplatte (31) der Leiterplatte (8) dazu ausgebildet sind, elektrisch miteinander verbunden zu werden und somit eine elektrische und/oder magnetische Abschirmsperre zwischen jedem Adernpaar (11-14) zu bilden.

2. RJ45-Stecker nach Anspruch 1,
**dadurch gekennzeichnet, dass** er ferner einen Metallmantel umfasst, der dazu ausgebildet ist, die Leiterplatte (8) wenigstens teilweise zu ummanteln, und die mittige elektrische und/oder magnetische Abschirmwand (28), die wenigstens eine Masse-platte (31) und der Metallmantel dazu ausgebildet sind, elektrisch miteinander verbunden zu werden und somit um jedes Adernpaar (11-14) im Wesentlichen ein einzelnes elektrisches und/oder magnetisches Abschirmgehäuse zu bilden.

3. RJ45-Stecker nach Anspruch 2,
**dadurch gekennzeichnet, dass** die mittige elektrische und/oder magnetische Abschirmwand (28) mit einem oberen Ende und einem dem oberen Ende entgegengesetzt angeordneten unteren Ende und wenigstens einer Vorwölbung (221, 222) versehen ist, die auf wenigstens einem der oberen und/oder unteren Enden vorstehend angeordnet und dazu ausgebildet ist, wenigstens teilweise in wenigstens einer in dem Metallmantel ausgebildeten Höhlung (255, 256, 355, 356) aufgenommen zu werden.

4. RJ45-Stecker nach einem der Ansprüche 2 oder 3,
**dadurch gekennzeichnet, dass** er ferner Kontaktplättchen (10), die dazu ausgebildet sind, auf der Leiterplatte (8) befestigt zu werden, und einen Kontaktkörper (16) aufweist, der dazu ausgebildet ist, auf den Kontaktplättchen (10) montiert zu werden, und der Metallmantel mit einem rückspringenden Abschnitt (360) und/oder einem erhabenen Abschnitt (361) versehen ist, gegen den der Kontaktkörper (16) angeordnet ist.

5. RJ45-Stecker nach einem der Ansprüche 2 oder 3,
**dadurch gekennzeichnet, dass** er ferner ein Schnappteil (17) umfasst, das dazu ausgebildet ist, den Stecker (5, 6) in einer Steckbuchse zu blockieren, in der der Stecker (5, 6) angebracht ist, und der Metallmantel mit einem rückspringenden Abschnitt (260) und/oder erhabenen Abschnitt (261) versehen ist, gegen den das Schnappteil (17) angeordnet ist.

6. RJ45-Stecker nach einem der Ansprüche 2 bis 5,
**dadurch gekennzeichnet, dass** der Metallmantel aus zwei Teilen gebildet ist, nämlich einem Steckerkörper (18), der zur Aufnahme der Leiterplatte (8) und des Anschlussverbreiterungssystems (9) ausgebildet ist, und einer Steckerkappe (19), die zur Anbringung auf dem Steckerkörper (18) und zum Bedecken der Leiterplatte (8) und des Anschlussverbreiterungssystems (9) ausgebildet ist.

7. RJ45-Stecker nach einem der Ansprüche 2 bis 6,
**dadurch gekennzeichnet, dass** die Leiterplatte (8) mit wenigstens einer Einkerbung (36) versehen ist, die auf wenigstens einer Seite (33, 34) der Leiterplatte (8) ausgebildet ist, und der Metallmantel mit wenigstens einem Kontaktstück (259) versehen ist, das dazu ausgebildet ist, mit der wenigstens einen Einkerbung (36) derart zusammenzuwirken, dass eine elektrische Verbindung zwischen der wenigstens einen Masseplatte (31) und dem Metallmantel hergestellt wird.

8. RJ45-Stecker nach einem der Ansprüche 2 bis 7,
**dadurch gekennzeichnet, dass** das Anschlussverbreiterungssystem (9) ferner selbstabisolierende Kontaktsysteme (229) umfasst, die zum Herstellen einer elektrischen Verbindung zwischen den Adernpaaren (11-14) und den Leiterbahnen (41-46) der Leiterplatte (8) ausgebildet sind, wobei jedes selbstabisolierende Kontaktsystem (229) mit zwei selbstabisolierenden Kontaktorganen (230) und einem Formkörper (231) versehen ist, der dazu ausgebildet ist, die selbstabisolierenden Kontaktorgane (230) wenigstens teilweise aufzunehmen und elektrisch voneinander zu trennen, wobei der Erweiterungskörper (26) des Anschlussverbreiterungssystems (9) zwei Positionierungsteile (223) umfasst, die auf der mittigen Wand (28) beidseits der Aussparung (27) montiert sind, und jeder Formkörper (231) sowohl auf einem jeweiligen Positionierungsteil (224) als auch auf dem Trennkörper (25) befestigt ist.

9. RJ45-Stecker nach Anspruch 8,
**dadurch gekennzeichnet, dass** wenigstens ein Positionierungsteil (223) eine Außenseite (228) aufweist, auf der wenigstens eine Anlagefläche (227) ausgebildet ist, und der Metallmantel mit wenigstens einem Kontakt- und Positionierungsorgan (257, 357) versehen ist, das dazu ausgebildet ist, gegen die wenigstens eine Anlagefläche (227) in Anlage gebracht zu werden; und/oder wenigstens ein Positionierungsteil (223) seitliche Höcker (276) aufweist und der Metallmantel wenigstens eine Innenseite (250) aufweist, die mit Nuten (277) versehen ist, die dazu ausgebildet sind, mit den seitlichen Höckern (276) zusammenzuwirken.

10. RJ45-Stecker nach einem der Ansprüche 8 oder 9,
**dadurch gekennzeichnet, dass** jeder Formkörper (231) mit einer zur Aussparung (27) gerichteten Bodenfläche (237), drei Längstrennwänden (235), die mit Abstand zueinander angeordnet sind und auf der der Bodenfläche (237) entgegengesetzten Seite verlaufen, zwei Einsteckschlitzen (236) versehen ist, die jeweils zwischen zwei aufeinanderfolgende Trennwände (235) angeordnet sind und in dem Formkörper (231) jeweils quer soweit verlaufen, bis sie in die Bodenfläche (237) münden, und jedes selbstabisolierendes Kontaktorgan (230) jeweils in einen solchen Einsteckschlitz (236) eingeführt ist und beidseits des Schlitzes vorsteht.

11. RJ45-Stecker nach einem der Ansprüche 8 bis 10,
**dadurch gekennzeichnet, dass** jeder Formkörper (231) mit einer Bodenfläche (237) und wenigstens einer Rippe (238) versehen ist, die auf der Bodenfläche (237) angeordnet ist und in die in dem Erweiterungskörper (26) ausgebildete Aussparung (27) vorspringt, wobei die wenigstens eine Rippe (238) dazu ausgebildet ist, die Leiterplatte (8) in der Aussparung (27) zu führen.

12. RJ45-Stecker nach einem der Ansprüche 8 bis 11,
**dadurch gekennzeichnet, dass** der Trennkörper (25) mit ersten Haltelaschen (218) versehen ist, die sich jeweils zu einem der Positionierungsteile (223) erstrecken, der wenigstens mit einer zweiten Haltelasche (226) versehen ist, die sich jeweils gegenüber einer der ersten Haltelaschen (218) erstreckt, und jeder Formkörper (231) mit zwei zangenförmigen Enden versehen ist, die jeweils auf einer solchen ersten Haltelasche (218) und einer dieser gegenüberliegenden zweiten Haltelasche (226) angebracht sind.

13. RJ45-Stecker nach einem der Ansprüche 2 bis 12,
**dadurch gekennzeichnet, dass** der Trennkörper (25) eine kreuzförmige Metallbasis mit einer mittigen Wand (212) und zwei beidseits der mittigen Wand (212) angeordneten Seitenwänden (213) umfasst, wobei die mittige Wand (212) ein oberes Ende und ein dem oberen Ende entgegengesetzt angeordnetes unteres Ende und wenigstens eine Vorwölbung (220) aufweist, die an wenigstens einem der oberen und/oder unteren Enden vorspringend angeordnet und dazu ausgebildet ist, wenigstens zum Teil in wenigstens einer in dem Metallmantel ausgebildeten Höhlung (246, 255, 346, 355) aufgenommen zu werden.

14. RJ45-Stecker nach einem der Ansprüche 2 bis 13,
**dadurch gekennzeichnet, dass** der Trennkörper (25) eine kreuzförmige Metallbasis mit einer mittigen Wand (212) und zwei Seitenwänden (213) umfasst, die beidseits der mittigen Wand (212) angeordnet sind und jeweils einen mit seitlichen Höckern (217, 275) versehenen Abschnitt (215) aufweisen, und der Metallmantel wenigstens eine Innenseite (250, 350) aufweist, die mit Nuten (251, 277, 351) versehen ist, die dazu ausgebildet sind, mit den seitlichen Höckern (217, 275) zusammenzuwirken.

15. RJ45-Anschlusskabel, das zum Verbinden von elektronischen Geräten und/oder Hardware untereinander ausgebildet ist, mit einem elektrischen Kabel (2) mit einem ersten Ende (3) und einem dem ersten Ende (3) entgegengesetzt angeordneten zweiten Ende (4), einer Isolierhülle (15) und vier von der Isolierhülle (15) ummantelten Adernpaaren (11-14); und wenigstens einem RJ45-Stecker (5, 6) nach einem der Ansprüche 1 bis 14, der auf wenigstens einem solchen ersten Ende (3) und/oder zweiten Ende (4) des Kabels (2) angebracht ist.

## Claims

1. A male RJ45 connector for an RJ45 electrical connection cord provided with a cable (2) having four pairs of conducting wires (11-14) that are configured to be electrically connected to said male connector (5, 6), which connector comprises a printed circuit (8) having a first face (23) and a second face (24) which is an opposite face to said first face (23), as well as a plurality of electrical conveyance tracks (41-46) to which said pairs of conducting wires (11-14) are configured to be connected electrically, a spreader system (9) mounted on said printed circuit (8) and configured to separate, electrically insulate and electrically shield said pairs of conducting wires (11-14) from each other; said male connector (5, 6) being **characterized in that**:
- said printed circuit (8) comprises at least one earthing plate (31) sandwiched between its first and second faces (23, 24) and a central throughslot (38) extending longitudinally in said printed circuit (8) and opening on a side (20) of said printed circuit (8), said central through-slot (38) being configured to pass through both said first and second faces (23, 24) and said at least one electrical earthing plate (31);
- said spreader system (9) comprises a separator body (25) and an extension body (26) projecting from said separator body (25), said extension body (26) being provided with a hollow (27) configured to receive said printed circuit (8) and an electrically and/or magnetically shielding central wall (28) dividing said hollow (27) into two parts and being configured to be inserted at least mostly into said central through-slot (38) of said printed circuit (8);
and said electrically and/or magnetically shielding central wall (28) and said at least one earthing plate (31) of said printed circuit (8) are configured to be electrically interconnected and thus form an electrically and/or magnetically shielding barrier between each pair of conducting wires (11-14).

2. A male RJ45 connector according to claim 1, **characterized in that** it further comprises a metallic envelope configured to envelope said printed circuit (8), at least partially, and said electrically and/or magnetically shielding central wall (28), said at least one earthing plate (31) and said metallic envelope are configured to be electrically interconnected and thus substantially form an individual electrically and/or magnetically shielding cage around each pair of conducting wires (11-14).

3. A male RJ45 connector according to claim 2, **characterized in that** said electrically and/or magnetically shielding central wall (28) is provided with an upper end and a lower end which is an opposite end to said upper end, and at least one projection (221, 222) provided projecting from at least one said upper and/or lower end and configured to be at least partially received in at least one cavity (255, 256, 355, 356) formed in said metallic envelope.

4. A male RJ45 connector according to one of claims 2 and 3, **characterized in that** said male connector further comprises contact blades (10) configured to be fastened to said printed circuit (8) and a contact body (16) configured to be mounted on said contact plates (10), and said metallic envelope is provided with a recessed portion (360) and/or a proud portion (361) against which is positioned said contact body (16).

5. A male RJ45 connector according to one of claims 2 and 3, **characterized in that** it further comprises a snap-engaging part (17) configured to immobilize said male connector (5, 6) in a female connector in which said male connector (5, 6) is configured to be mounted, and said metallic envelope is provided with a recessed portion(260) and/or a proud portion (261) against which is positioned said snap-engaging part (17).

6. A male RJ45 connector according to any one of claims 2 to 5, **characterized in that** said metallic envelope is formed in two parts, respectively a connector body (18) configured to receive said printed circuit (8) and said spreader system (9), as well as a connector cover (19) configured to be mounted on said connector body (18) and to cover said printed circuit (8) and said spreader system (9).

7. A male RJ45 connector according to any one of claims 2 to 6, **characterized in that** said printed circuit (8) is provided with at least one notch (36) formed on at least one side (33, 34) of said printed circuit (8) and said metallic envelope is provided with at least one contact lug (259) configured to cooperate with said at least one notch (36) so as to establish an electrical connection between said at least one earthing plate (31) and said metallic envelope.

8. A male RJ45 connector according to any one of claims 2 to 7, **characterized in that** said spreader system (9) further comprises self-stripping contact systems (229) configured to establish an electrical connection between said pairs of conducting wires (11-14) and said electrical conveyance tracks (41-46) of said printed circuit (8), each self-stripping contact system (229) being provided with two self-stripping contact members (230) and with a molded body (231) that is configured to receive at least partially and to electrically insulate from each other said self-stripping contact members (230), said extension body (26) of said spreader system (9) comprises two positioning parts (223) mounted on said central wall (28) on respective opposite sides of said hollow (27), and each molded body (231) is fastened both to a respective said positioning part (223) and to said separator body (25).

9. A male RJ45 connector according to claim 8, **characterized in that** at least one said positioning part (223) has an outside face (228) on which is formed at least one bearing surface (227) and said metallic envelope is provided with at least one contact and positioning member (257, 357) which is configured to come to bear on said at least one bearing surface (227); and/or at least one said positioning part (223) has lateral bosses (276) and said metallic envelope has at least one inside face (250) provided with grooves (277) which are configured to cooperate with said lateral bosses (276).

10. A male RJ45 connector according to one of claims 8 and 9, **characterized in that** each molded body is (231) provided with a base face (237) turned towards said hollow (27), with three longitudinal small walls (235) situated apart from each other and extending remotely from said base face (237), two insertion spaces (236) each provided between two successive small walls (235) and each extending transversely in said molded body (231) until they open onto said base face (237), and each self-stripping contact member (230) is inserted into a respective said insertion space (236) and projects on respective opposite sides of said space;

11. A male RJ45 connector according to any one of claims 8 to 10, **characterized in that** each molded body (231) is provided with a base face (237) and with at least one rib (238) formed on said base face (237) and projecting into said hollow (27) formed in said extension body (26), said at least one rib (238) being configured to guide said printed circuit (8) into said hollow (27).

12. A male RJ45 connector according to any one of claims 8 to 11, **characterized in that** said separator body (25) is provided with first attachment lugs (218) extending towards a respective said positioning part (223) which is provided with at least one second attachment lug (226) extending facing a respective said first attachment lug (218), and each molded body (231) is provided with two pincer-shaped ends respectively mounted on a said first attachment lug (218) and on a second said attachment lug (226) facing the latter.

13. A male RJ45 connector according to any one of claims 2 to 12, **characterized in that** said separator body (25) comprises a cross-shaped metallic base having a central wall (212) and two lateral walls (213) disposed on respective opposite sides of the central wall (212), said central wall (212) having an upper end and a lower end which is an opposite end to said upper end, and at least one projection (220) formed projecting from at least one said upper and/or lower end and configured to be at least partially received in at least one cavity (246, 255, 346, 355) formed in said metallic envelope.

14. A male RJ45 connector according to any one of claims 2 to 13, **characterized in that** said separator body (25) comprises a cross-shaped metallic base having a central wall (212) and two lateral walls (213) disposed on respective opposite sides of the central wall (212) and each having a portion (215) provided with lateral bosses (217, 275), and said metal envelope has at least one inside face (250, 350) provided with grooves (251, 277, 351) which are configured to cooperate with said lateral bosses (217, 275).

15. An RJ45 connection cord configured to interconnect items of electronic and/or computer equipment, comprising an electric cable (2) having a first end (3) and a second end (4) which is an opposite end to the first end (3), an insulating sheath (15) and four pairs of conducting wires (11-14) enveloped in said sheath (15); and at least one male RJ45 connector (5, 6) according to any one of claims 1 to 14, mounted on at least one said first end (3) and/or second end (4) of said cable (2).
